Europäisches Patentamt

European Patent Office

Office européen des brevets

(11) Publication number: **0 520 558 A1**

# EUROPEAN PATENT APPLICATION

(21) Application number: **92201792.6**

(22) Date of filing: **19.06.92**

(51) Int. Cl.⁵: **H03L 7/089**, H03L 7/099

(30) Priority: **27.06.91 EP 91201635**

(43) Date of publication of application:
**30.12.92 Bulletin 92/53**

(84) Designated Contracting States:
**DE FR GB**

(71) Applicant: **N.V. Philips' Gloeilampenfabrieken**
**Groenewoudseweg 1**
**NL-5621 BA Eindhoven(NL)**

(72) Inventor: **Yang, Tsung Nung**
**c/o INT. OCTROOIBUREAU B.V., Prof.**
**Holstlaan 6**
**NL-5656 AA Eindhoven(NL)**

(74) Representative: **Strijland, Wilfred et al**
**INTERNATIONAAL OCTROOIBUREAU B.V.**
**Prof. Holstlaan 6**
**NL-5656 AA Eindhoven(NL)**

(54) **Phase locked loop and digital phase comparator for use in a phase-locked loop.**

(57) A digital phase comparator comprises input logic gates (15, 16) and output logic gates (17, 18). The output of each input logic gate (15, 16) is coupled to one of the inputs of an output logic gate (17, 18) *via* delay elements (19, 20). Due to these delay elements, the respective inputs of the output logic gates are maintained for a time interval after the reversal of input signals on the inputs (11, 12) of the digital phase comparator. Transients that would occur when both input signals change simultaneously are thereby suppressed. The suppression of the transients makes the phase comparator in particular suitable for use in a phase locked loop to provide a clock signal in a character generator for a television display.

FIG.2

The invention relates to a phase locked loop comprising a

- digital phase comparator having a reference input and an oscillator input, and up and down outputs,
- charge pump means with inputs coupled to the up and down outputs of the digital phase comparator, which charge pump means has an output coupled to an input of
- a voltage controlled oscillator (VCO), the VCO being provided with an output coupled to said oscillator input of the digital phase comparator,
- the reference input of the digital phase comparator being an input of a reference input logical gate,
- the oscillator input of the digital phase comparator being an input of an oscillator input logical gate,
- the up output of the digital phase comparator being an output of an up output logical gate and
- the down output of the digital phase comparator being an output of a down output logical gate,

wherein an output of the reference input logical gate is coupled to an input of one of the up and down output logical gates and an output of the oscillator input logical gate is coupled to a input of the other of the up and down output logical gates. The invention also relates to a digital phase comparator suitable for use in such a phase locked loop and a character generator comprising such a phase locked loop.

A phase locked loop (PLL) can be used in may applications in which an clock signal is to be synchronised with an external reference signal. An output of the PLL then provides an oscillation signal for use as a clock signal. Via a feedback circuit the phase of the oscillation signal is compared with the phase of the reference signal and, in case a difference between the two exists, the frequency of the oscillation signal is adjusted to decrease the phase difference. An application for a PLL is in a character generator for generating characters on a display such as a screen of a television receiver, CD-video players, camera recorders and television monitors for displaying so-called On Screen Display (OSD) information. To achieve stable characters on the screen the clock signal has to be synchronised with the line-synchronising signal of the television receiver.

A PLL and a digital phase comparator as described in the introductory paragraph are known, for example from GB-A 2 075 294. It was found that such a phase comparator, and also the PLL, has as a serious disadvantage that transients occur when the external reference signal and the oscillation signal from the VCO lock, *i.e.* when the falling edges of the two signals are aligned, on which edges the phase comparison is effected. Due to this effect known PLLs are unfit for certain applications, such as providing an internal clock signal in a character generator for a television display, because the transients make the generated characters unstable. In particular this holds true when the PLL is arranged to provide clock signals of various frequencies. The frequency of the clock signal during the visible portion of a television line determines the width of the characters. Changing between different frequencies is desirable because it allows the use of differently sized characters using one and the same character generator.

It is, *inter alia,* an object of the invention to provide a PLL, suitable for application in a character generator for a television receiver in which a wide frequency range can be obtained without observable jittering of the displayed characters.

It is a further object of the invention to obtain a PLL that can be integrated using a CMOS technology. The use of CMOS technology allows a compact circuit with low power consumption.

It is another object of the invention to provide a character generator with little sensitivity to electro-magnetic-interference.

To this end a PLL according to the invention is characterised in that the said outputs of the input logical gates are coupled to said inputs of the output logical gates *via* signal delay means. It was found that when the timing delay between the mentioned logical gates was elongated the transients at the outputs were reduced substantially. The suppression of the transients occurs for all frequencies within a wide range. As both the gates and the necessary delay elements can be easily obtained and integrated using CMOS technology a compact circuit with low power consumption can be achieved.

Integration of a PLL as clock source in a character generator means none or very few external components and leads to those components. The reduced total lead length alleviates sensitivity for electro-magnetic-interference.

It is remarked that the digital phase comparator known from the before-mentioned GB-A 2 075 294 has a delay line connected to the inputs of the output logical gates. However, this delay line is common for both gates, and is coupled to the outputs of the input logical gates *via* further logical circuitry coupling it to the output of both input logical gates. The purpose of the delay line is to create output pulses from the digital phase comparator of a sufficient duration and amplitude, not to inhibit the occurrence of transients at the outputs in the case the reference and oscillation signals are locked.

Embodiments of a PLL according to the invention are further characterised in that the signal delay means comprises a series arrangement of at least two logic invertors, or comprises AND-gates with interconnected inputs, or comprises poly-line, or a combination of said delay devices. The use of invertors, or of NAND or AND-gates with interconnected inputs, provides delay elements that are easy to be integrated together with the other elements of the circuit. The use of poly-line on an integrated circuit is well known and it provides a delay line which occupies relatively little surface area.

An advantageous embodiment of the PLL in accordance with the invention is characterised in that a programmable counter is arranged between the output of the VCO and the oscillator input of the digital phase comparator. The counter acts as a programmable divider and allows the output frequency of the PLL, that is the oscillation frequency of the VCO, to be a adjustable multiple of the frequency of the reference signal. This is in particular advantageous as the efficient suppression of the transients is possible for a wide range of frequencies.

A further embodiment of the PLL according to the invention is wherein the charge pump means comprises an output of which the output level is regulated in between two supply voltage levels at first and second supply terminals, respectively, and further characterised in that the charge pump means is provided with a control input for inhibiting the existence of a d.c. path between said supply terminals when the charge pump means is not in use. This allows an "idle mode" in which the charge pump means does consume almost no power. This is advantageous in an application for a battery driven appliance, such as a display in a camcorder, where power consumption is a major concern.

This embodiment may further be characterised in that the charge pump means comprise a first transistor for regulating a current between the first supply terminal and the output and a second transistor for regulating a current between the second supply terminal and the output and in that the control input is arranged for switching off both transistors simultaneously. A simple solution is obtained with no additional switches in the path between the terminals and the output of the charge pump means and little further circuitry. The control signal may be applied to the gates of the transistors via a logical combination with the input signals of the charge pump means to force the signals at the gates to a predetermined level.

Another embodiment of the PLL according to the invention is characterised in that the VCO comprises a ring-oscillator with a chain of cells, the delay occurring in each cell being dependent upon control voltages at control terminals coupled to the cell, in that the VCO further comprises means for regulating said control voltages, and in that the VCO is provided with a control input for inhibiting the generation of at least one of said control voltages when the VCO is not in use. This embodiment comprises an "idle mode" of the VCO. As stated before, this is advantageous in an application for a battery driven appliance. It is remarked that a VCO of which the frequency is controlled by its input voltages is known *perse* from US-A 4 871 979. However, that document does not disclose a control input for inhibiting dissipation in the VCO when the latter is not needed.

The invention also relates to a digital phase comparator and a character generator for an OSD-controller. A digital phase comparator in accordance with the invention comprises a reference input and an oscillator input, and up and down outputs

- the reference input of the digital phase comparator being an input of a reference input logical gate,
- the oscillator input of the digital phase comparator being an input of an oscillator input logical gate,
- the up output of the digital phase comparator being an output of an up output logical gate and
- the down output of the digital phase comparator being an output of a down output logical gate,

wherein an output of the reference input logical gate is coupled to an input of one of the up and down output logical gates and an output of the oscillator input logical gate is coupled to an input of the other of the up and down output logical gates, and is characterised in that said outputs of the input logical gates are coupled to said inputs of the output logical gates *via* signal delay means. As already mentioned before, this allows an efficient suppression of transients, which makes a PLL with such a digital phase comparator suitable for use in a character generator with a wide range of frequencies. The character generator, which in a television-like application, is locked to the horizontal synchronising signal, can then be used to generate characters of different sizes without observable jittering. The differently sized characters may occur within one screen of displayed text, or may occur in different screens only or even in different apparatuses only. In the latter case the present invention allows the use of identical circuits to be used in different types of appliances. It is no longer necessary to design a different circuit for each type of apparatus.

These and other, more detailed, aspects of the invention will be apparent from and elucidated with reference to the drawings and embodiments described hereinafter.

The drawings show in

Figure 1 diagrammatically a phase locked loop in accordance to the invention;

Figure 2 diagrammatically an embodiment of a digital phase comparator suitable for application in the phase locked loop;

Figure 3 diagrammatically a charge pump provided with circuitry to inhibit a d.c. current between the power supply terminals;

Figure 4 diagrammatically a voltage controlled oscillator with a control input to inhibit dissipation;

Figure 5 a block diagram of a character generator in accordance with the invention.

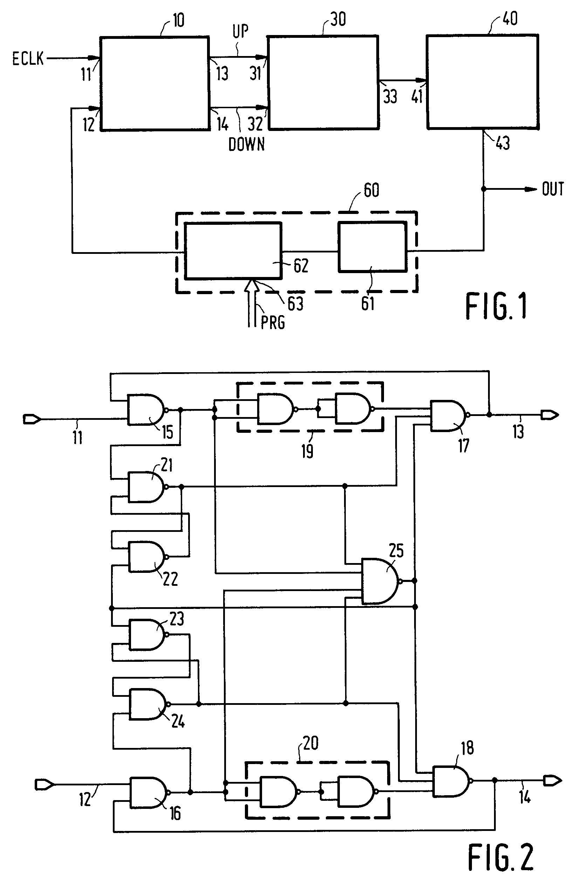

In Figure 1 a phase locked loop (PLL) in accordance with the invention is diagrammatically shown. The PLL comprises a digital phase comparator 10 with two inputs 11 and 12 and two outputs 13 and 14. Both outputs, referred to as the UP output 13 and the DOWN output 14 are connected to two inputs, the UP and DOWN inputs 31 and 32 of a charge pump 30. The charge pump has an output 33 connected to the input 41 of a voltage controlled oscillator (VCO) 40. The output 43 of the VCO is coupled to one of the inputs, the oscillator input 12, of the digital phase comparator. The other input, the reference input 11, of the digital phase comparator is coupled to an external clock signal ECLK. In the signal path from the output 43 of the VCO 40 to the oscillator input 12 of the digital phase comparator a counter 60 in arranged.

The phase locked loop functions as follows. In the digital phase comparator 10 the phases of the two signals at the reference input 11 and at the oscillator input 12 are compared. When there is a phase difference between the two signals deviates from a value, a pulse is generated at one of the outputs 13 or 14 of the comparator. For example, when the reference signal is leading the oscillator signal a pulse is generated at the UP output 13, when the reference signal is trailing the oscillator signal a pulse is generated at the DOWN output 14. The length of the pulse is related to the magnitude of the phase difference between the two signals. The charge pump 30 translates the pulse into an increase or a decrease of the voltage level that is available at its output 33. This output voltage level is input to the VCO 40 via the input terminal 41. The VCO 40 generates an oscillation signal of which the frequency is proportional to the voltage at its input 41. As this oscillation signal is transmitted to the oscillator input 12 of the phase comparator 10, the oscillation signal is normally synchronised with (locked to) the reference signal.

The counter 60 acts as a frequency divider so that the VCO operates at a frequency which is a multitude of the frequency of the reference signal ECLK. In the embodiment shown in Figure 1 the counter 60 consists of two portions. The first portion 61 is a fixed divider, for example a divide-by-16 counter. In series therewith the second programmable portion is placed, for example a 7-bit programmable counter. The programmable counter is provided with a programming input 63 for a selection signal PRG to program the counter at a desired maximum counting value. With these counters the frequency of the VCO can be programmed to any value between 16 times and $128 \times 16 = 2048$ times the reference frequency, provided of course that all components of the circuit are able to handle these frequencies.

A digital phase comparator according to the invention is shown in Figure 2. The basic phase comparator, consisting of four flip-flops each formed by a pair of interconnected NAND-gates is known in the art. The four flip-flops can be identified as the NAND-gates 15 and 17 in between in reference input 11 and the UP output 13; the pair of NAND-gates 16 and 18 in between the oscillator input 12 and the DOWN output 14; the pair 21 and 22; and the pair 23 and 24. Such a digital phase comparator, for example described in the before mentioned GB-A 2 075 294, acts at the falling edge of the input signals. Normally both outputs carry a logical high signal. When the falling edge of the reference signal leads the falling edge of the oscillator signal, the UP output 13 is switched to logic low and when the falling edge of the reference signal trails the falling edge of the oscillator signal the DOWN output 14 is switched to logic low.

It was found that when simultaneous transitions occur of the reference signal and of the oscillation signal, *i.e.* when the two signals are locked, an instable situation of the flip-flops occurs which gives rise to transients at the outputs 13 and 14. In a PLL these transients are highly undesirable as they interfere with the proper operation of the charge pump.

The digital phase comparator shown in the Figure is provided with delay elements 19 an 20 in the flip-flop coupling the reference input and the UP output, and in the flip-flop between the oscillator input and the DOWN output. The delay elements 19 and 20 are arranged in the inputs of output NAND-gates 17 and 18, respectively. The delays in these delay elements cause the other flip-flops, formed by NAND-gates 21-22 and NAND-gates 23-24 and the interconnecting NAND gate 25 to be stabilised prior to the arrival of the output signals of the input NAND-gates 15 and 16 at the respective inputs of the output NAND-gates 17 and 18. As the relevant inputs of the output NAND gates are maintained for a while at the former level, no instabilities occur at the level of the UP and DOWN output signals.

The delay lines shown in the Figure are formed by an even number of invertors, each invertor in turn being a NAND-gate with its inputs connected to each other. The necessary delay can also be generated by other means, for example the use of poly-line, *i.e.* poly-crystalline silicon used as a conductor. A combination of the various possibilities to generate a delay can be applied as well. The choice will depend on the amount of delay necessary and the technology in which the circuit is to be implemented.

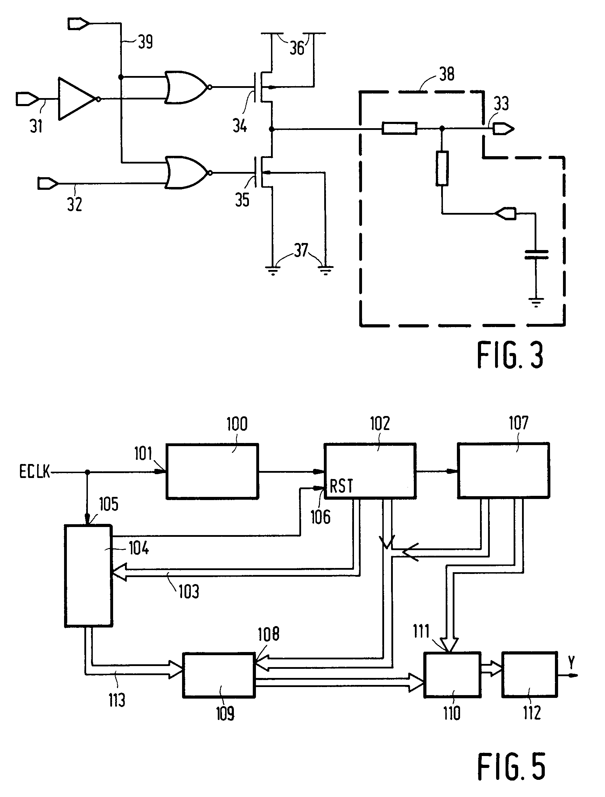

In Figure 3 a block diagram of a charge pump for use in the PLL is shown. The charge pump comprises two transistors 34 and 35, for example FETs, placed in series between two power supply terminals 36 and 37. The transistors 34 and 35 are of opposite conductivity type, for example a PMOS and an NMOS FET, when the circuit is implemented in CMOS technology as shown in the Figure. The junction between the transistors is coupled to a low-pass RC-filter 38, whose output is the output 33 of the charge pump. The low-pass RC-filter 38 is referred to as the loop filter.

The two FETs 34 and 35 act as two electronic switches. When the signal at the UP input 31 is activated (low), *i.e.* when the reference signal leads the oscillator signal, the PMOS-FET 34 is turned on to charge the capacitance in the loop filter 38. The voltage level at the output 33 rises, which in turn will increase the frequency of the VCO 40, thus dragging the oscillator output signal in the direction of synchronisation with the reference signal.

When the reference signal is trailing the oscillator signal, the signal at the DOWN input 32 goes low and the NMOS FET is turned on. The capacitance discharges and the potential at the output 33 decreases. Consequently, the oscillation frequency of the VCO 40 is decreased, also dragging the output signal of the VCO in the direction of synchronisation with the reference signal.

When the oscillator and the reference signals are synchronised, neither input will be activated, both FETs are maintained in their non-conducting state and the voltage level at the output 33 is kept virtually constant. The oscillation frequency of the VCO is fixed.

Depending on the required value of the capacitance in the loop filter 38, this capacitor can be integrated on a single integrated circuit comprising the complete PLL, or when for stability reasons a larger capacitance is needed, an external capacitor can be used. When an implementation as an integrated circuit with an external capacitor is used the latter will be the only external element of the PLL. As no other external leads are necessary, the sensitivity of the circuit for electro-magnetic-interference, a major cause of disturbance, is minimal.

In the connection between the inputs of the charge pump and the gates of the FETs 34 and 35 invertors are arranged, two in between the UP input 31 and the gate of FET 34 and one in between the DOWN input 32 and the gate of FET 35. As shown in the Figure, in each connection one of the invertors is formed by a two-input logical NOR-gate of which one input is coupled to the UP and DOWN inputs respectively, and the other input is coupled to a control input 39. When the control input 39 is activated, both FETs 34 and 35 are turned off and no d.c. connection exists between the power supply terminals 36 and 37. So, the charge pump is an "idle mode" with minimal power dissipation.

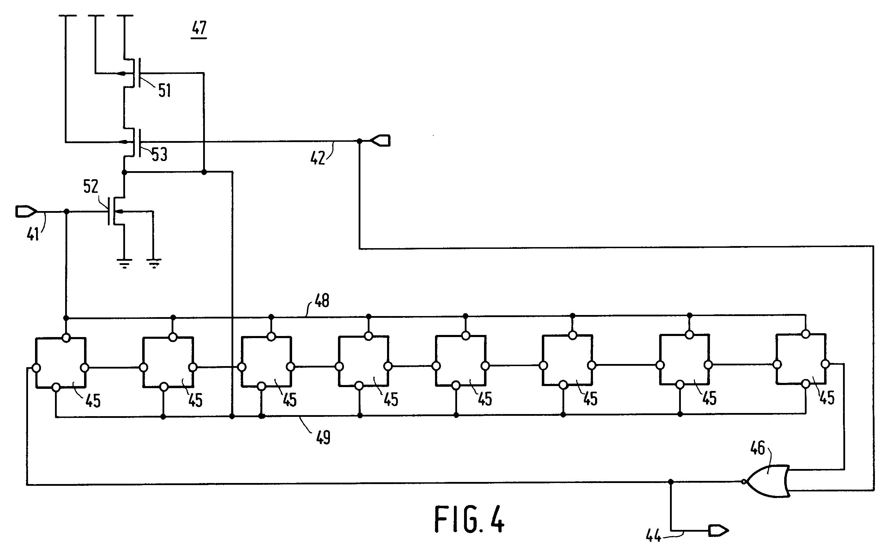

Figure 4 shows diagrammatically an embodiment of a VCO suitable for use in a PLL according to the invention. The VCO comprises an even number of delay cells 45 and an invertor 46. Each delay cell 45 has a invertor function, forming a ring oscillator. The output 44 of the VCO is derived from the output of the invertor 46. In order to reduce the load on the output 33 of the loop filter 38 an input buffer, formed by transistors 51 and 52 is placed between the input 41 and the ring oscillator. In an CMOS implementation of the circuit the buffer consists of an series arrangement of a PMOS and an NMOS FET. Each of the delay cells generates a delay which is related to the control voltages at the control terminals 47 and 48. By changing the control voltages the oscillation frequency is changed. The voltages at the control terminals 47 and 48 are derived *via* the input buffer 51, 52 from the voltage at the VCO input 41. Each of the delay cells 45 consists of an odd number of concatenated invertors. In at least one of these invertors the current flow and thereby the delay in the cell is regulated by the control voltages.

In the embodiment shown, the invertor 46 is formed by a NOR-gate of which one input is connected to the last delay cell and the other input is coupled to an control input 42 of the VCO. The control input 42 is also coupled to a switch 53 in the input buffer. Activation of the control input 42 leads to a voltage level at the control terminal 48 that is equal to ground. In that case each of the delay cells 45 falls in a stable position, independent of the respective input voltage level in which stable position no supply current flows through the delay cell. At the same time the output of the invertor 46 is kept constant so that the ring oscillator stops. The VCO has entered the "idle mode" in which very low power consumption occurs.

In Figure 5 the structure of a character generator is diagrammatically shown. The character generator comprises a PLL 100 with a reference input 101 to which a periodical reference signal ECLK can be applied. In a television-like application the reference signal is the horizontal line or synchronising signal. The PLL supplies an output clock signal of a frequency that is a multitude of the frequency of the reference signal and that is synchronised with the same. The output clock signal is applied to a counter 102. The counter 102 generates a counting value and supplies it via a connection 103 to a control circuit 104. The control circuit also receives the reference or line signal ECLK at an input 105 and can apply a reset signal to an input 106 of the counter 102. In a practical implementation the control circuit 104 may comprise a microprocessor, for example of the type 84C640 of Phillps. The input 105 is then preferably a so-called "interrupt request" input.

The counter 102 is further adapted to generate a column number indicating the horizontal position of a character to be displayed. Moreover the counter 102 supplies a line pulse to a line and row counter 107. In response thereto, the line and row counter 107 generates a row number indicating the vertical position of the characters to be displayed, and a line number corresponding to the picture line to be displayed within the row determined by the row number. These column and row numbers constitute an address which is applied to an input 108 of an display memory 109 in which a character code is stored for the characters to be displayed. The character code addressed by the column and row numbers is applied to a character memory 110 which comprises a matrix composed of pixels for each character. The character memory further receives the line number from the line and row counter 107 at an input 111 and generates the pixels for each character which must be displayed in the line with the received line number. In a parallel to series convertor 112 the pixels obtained are successively applied as a pixel signal Y to an output for display on a display screen. The control circuit 104 is connected by means of an address and data bus 113 to the display memory 109 in order to store the character codes of the characters to be displayed.

**Claims**

1. A phase locked loop comprising a
   - digital phase comparator (10) having a reference input (11) and an oscillator input (12), and up and down outputs (13, 14),
   - charge pump means (30) with inputs (31, 32) coupled to the up and down outputs (13, 14) of the digital phase comparator, which charge pump means (30) has an output (33) coupled to an input (41) of

   - a voltage controlled oscillator (VCO) (40), the VCO (40) being provided with an output (43) coupled to said oscillator input (12) of the digital phase comparator (10),
   - the reference input (11) of the digital phase comparator being an input of a reference input logical gate (15),
   - the oscillator input (12) of the digital phase comparator being an input of an oscillator input logical gate (16),
   - the up output (13) of the digital phase comparator being an output of an up output logical gate (17) and
   - the down output (14) of the digital phase comparator being an output of a down output logical gate (18),
   
   wherein an output of the reference input logical gate (15) is coupled to an input of one of the up and down output logical gates (17, 18) and an output of the oscillator input logical gate (16) is coupled to an input of the other of the up and down output logical gates (17, 18), characterised in that said outputs of the input logical gates (15, 16) are coupled to said inputs of the output logical gates (17, 18) *via* signal delay means (19, 20).

2. A phase locked loop as claimed in Claim 1, characterised in that the signal delay means (19, 20) comprises a series arrangement of at least two logic invertors, or comprises AND-gates (21-24) with interconnected inputs, or comprises poly-line, or a combination of said delay devices.

3. A phase locked loop as claimed in claim 1 or 2, characterised in that a programmable counter (60) is arranged between the output (43) of the VCO (40) and the oscillator input (12) of the digital phase comparator (10).

4. A phase locked loop as claimed in Claim 1, 2 or 3, wherein the charge pump means (30) comprises an output (33) of which the output level is regulated in between two supply voltage levels at first and second supply terminals (36, 37), respectively, characterised in that the charge pump means (30) is provided with a control input (39) for inhibiting the existence of a d.c. path between said supply terminals (36, 37) when the charge pump means is not in use.

5. A phase locked loop as claimed in Claim 4, characterised in that the charge pump means comprise a first transistor (34) for regulating a current between the first supply terminal (36) and the output (33) and a second transistor (35) for regulating a current between the second supply terminal (37) and the output (33) and in that the control input (39) is arranged for switching off both transistors (34, 35) simultaneously.

6. A phase locked loop as claimed in Claim 1 or 2, characterised in that the VCO comprises a ring-oscillator with a chain of cells (45), the delay occurring in each cell (45) being dependent upon control voltages at control terminals (48, 49) coupled to the cell (45), in that the VCO further comprises means (47) for regulating said control voltages, and in that the VCO (40) is provided with a control input (42) for inhibiting the generation of at least one of said control voltages when the VCO is not in use.

7. A phase locked loop as claimed in any of the preceding Claims, characterised by its implementation in an integrated circuit using a CMOS technology.

8. A digital phase comparator (10) suitable for use in a phase locked loop according to any one of the preceding claims, comprising a reference input (11) and an oscillator input (12), and up and down outputs (13, 14),
   - the reference input (11) of the digital phase comparator being an input of a reference input logical gate (15),
   - the oscillator input (12) of the digital phase comparator being an input of an oscillator input logical gate (16),
   - the up output (13) of the digital phase comparator being an output of an up output logical gate (17) and
   - the down output (14) of the digital phase comparator being an output of a down output logical gate (18),
   wherein an output of the reference input logical gate (15) is coupled to an input of one of the up and down output logical gates (17, 18) and an output of the oscillator input logical gate (16) is coupled to an input of the other of the up and down output logical gates (17, 18), characterised in that said outputs of the input logical gates (15, 16) are coupled to said inputs of the output logical gates (17, 18) *via* signal delay means (19, 20).

9. An character generator comprising a phase locked loop (100) according to any one of the Claims 1 to 6, which character generator comprises a reference clock input for connecting thereto a line-synchronising signal (ECLK) which is connected to the reference input (101) of the phase locked loop (100).

FIG.1

FIG.2

FIG. 3

FIG. 5

FIG. 4

| European Patent Office | EUROPEAN SEARCH REPORT | Application Number |
|---|---|---|
| | | EP 92 20 1792 |

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | IEEE JOURNAL OF SOLID-STATE CIRCUITS. vol. SC-22, no. 2, April 1987, NEW YORK US pages 255 - 261 JEONG, BORIELLO, HODGES AND KATZ: 'Design of PLL-based clock generation circuits.' | 1,2,7,8 | H03L7/089 H03L7/099 |
| Y | * figure 3 * | 3 | |
| X | ELECTRONIC DESIGN vol. 36, no. 24, October 1988, HASBROUCK HEIGHTS, NEW JERSEY US FRANK GOODENOUGH: 'Mixed-mode simulators go beyond SPICE.' | 1,2,7,8 | |
| A | pages 77-80+82+87-91 * page 80 - page 82 * | 6 | |
| D,Y | GB-A-2 075 294 (RCA CORPORATION) * page 2, line 35 - line 36 * | 3 | |
| A | EP-A-0 335 370 (KABUSHIKI KAISHA TOSHIBA) * page 4, line 33 - line 36 * | 4,5 | |
| A | EP-A-0 238 041 (NEC CORPORATION) * abstract * | 4 | TECHNICAL FIELDS SEARCHED (Int. Cl.5) |
| A | EP-A-0 342 626 (KABUSHIKI KAISHA TOSHIBA) * abstract; figure 1 * | 6 | H03L H03D H04N |
| A | EP-A-0 180 450 (RCA CORPORATION) | 9 | |

The present search report has been drawn up for all claims

| Place of search | Date of completion of the search | Examiner |
|---|---|---|
| THE HAGUE | 01 OCTOBER 1992 | PEETERS M.M.G. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)